(19) **Europäisches Patentamt / European Patent Office / Office européen des brevets**

(11) **EP 4 394 939 A1**

(12) # EUROPEAN PATENT APPLICATION
published in accordance with Art. 153(4) EPC

(43) Date of publication:
**03.07.2024 Bulletin 2024/27**

(21) Application number: **22955284.9**

(22) Date of filing: **17.08.2022**

(51) International Patent Classification (IPC):
**H01M 4/485** (2010.01)    **H01M 4/505** (2010.01)
**H01M 4/525** (2010.01)

(52) Cooperative Patent Classification (CPC):
**H01M 4/485; H01M 4/505; H01M 4/525;**
Y02E 60/10

(86) International application number:
**PCT/CN2022/112965**

(87) International publication number:
**WO 2024/036502 (22.02.2024 Gazette 2024/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Ningde Amperex Technology Limited
Ningde, Fujian 352100 (CN)**

(72) Inventors:
• **CHENG, Shiyang**
  **Ningde, Fujian 352100 (CN)**
• **SHITABA, Jumpei**
  **Ningde, Fujian 352100 (CN)**
• **LANG, Ye**
  **Ningde, Fujian 352100 (CN)**
• **XU, Leimin**
  **Ningde, Fujian 352100 (CN)**

(74) Representative: **Icosa
83 avenue Denfert-Rochereau
75014 Paris (FR)**

(54) **POSITIVE ELECTRODE MATERIAL, ELECTROCHEMICAL APPARATUS AND ELECTRIC DEVICE**

(57)    A positive electrode material includes first monocrystalline particles, and the first monocrystalline particle has a first length-diameter ratio $L_1$, where Li satisfies $2 \le Li \le 5$. The positive electrode material includes the first monocrystalline particle having the first length-diameter ratio $L_1$, and a high length-diameter ratio of the first monocrystalline particle is conducive to reducing active crystal planes which cause side reactions on a surface of the positive electrode material, and suppressing structural phase change and interface side reactions of the positive electrode material, which leads to improved cycling performance and storage performance of the electrochemical apparatus at high voltage and high temperature.

FIG. 1

**Description**

**TECHNICAL FIELD**

This application relates to the field of electrochemical technologies, and in particular, to a positive electrode material, an electrochemical apparatus, and an electronic device.

**BACKGROUND**

With popularization of consumer electronic products such as notebook computers, mobile phones, tablet computers, mobile power supplies, and drones, requirements on electrochemical apparatuses therein are increasingly stringent. For example, the electrochemical apparatuses are not only required to be light but also required to have high capacity and long service life. Lithium-ion batteries have become the mainstream in the market due to their outstanding advantages such as high energy density, high safety, no memory effect, and long service life.

To implement higher energy density, the lithium-ion batteries have been developing toward the direction of increasing voltage and lithium deintercalation. In addition, during actual use, a high-temperature operating condition is inevitable. Under high-voltage, high-lithium-deintercalation, and high-temperature operating conditions, the problems of surface oxygen release and structural phase change of positive electrode materials are fully exposed, resulting in the problems such as drastic capacity decrease and gas production of batteries.

**SUMMARY**

In view of this, this application provides a positive electrode material, an electrochemical apparatus, and an electronic device, so as to solve some of the problems in the prior art.

According to a first aspect, this application provides a positive electrode material. The positive electrode material includes first monocrystalline particles, and the first monocrystalline particle has a first length-diameter ratio $L_1$, where $L_1$ satisfies $2 \leq L_1 \leq 5$. The positive electrode material includes the first monocrystalline particle having the first length-diameter ratio $L_1$, and a high length-diameter ratio of the first monocrystalline particle is conducive to reducing active crystal planes which cause side reactions on a surface of the positive electrode material, and suppressing structural phase change and interface side reactions of the positive electrode material, which leads to improved cycling performance and storage performance of an electrochemical apparatus at high voltage and high temperature.

In some embodiments, the surface of the first monocrystalline particle has a first crack. The crack on the surface of the first monocrystalline particle can allow the first monocrystalline particle to have a larger specific surface area, so as to facilitate intercalation and deintercalation of lithium ions inside the first monocrystalline particle, thereby increasing energy density of the electrochemical apparatus. In addition, due to the high length-diameter ratio of the first monocrystalline particle, great stress and strain are generated by expansion and contraction caused by lithium intercalation and deintercalation in a length-diameter direction. Expansion and contraction of the first monocrystalline particle in the length-diameter direction can be buffered through the crack on the surface of the first monocrystalline particle, reducing the risk of breaking of the first monocrystalline particle, thereby improving the cycling performance and storage performance of the electrochemical apparatus at high voltage and high temperature.

In some embodiments, an average particle size $D_1$ of the first monocrystalline particle is 10 $\mu$m to 25 $\mu$m.

In some embodiments, a wall surface of the first crack includes at least one of element P, element F, or element N. The inside of the first crack including at least one of element P, element F, or element N can improve stability of a crystal structure of the first monocrystalline particle at the first crack and suppress phase change of the crystal structure and interface side reactions at the first crack, thereby improving the cycling performance and storage performance of the electrochemical apparatus at high voltage and high temperature.

In some embodiments, a width h of the first crack is less than or equal to 0.1 $\mu$m. The width h of the first crack being within the foregoing range is conducive to suppressing the interface side reactions, thereby improving the cycling performance and storage performance of the electrochemical apparatus at high voltage and high temperature.

In some embodiments, the first monocrystalline particle includes a first lithium nickel composite oxide.

In some embodiments, the first lithium nickel composite oxide contains element Ni, element Na, optionally element Co, optionally element Mn, optionally element M, and optionally element R, where element M includes at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and element R includes at least one of P, F, or N.

In some embodiments, based on a total molar mass of element Ni, element Co, element Mn, and element M in the first lithium nickel composite oxide, a molar percentage of element Na in the first lithium nickel composite oxide is 1% to 10%.

In some embodiments, based on the total molar mass of element Ni, element Co, element Mn, and element M in the first lithium nickel composite oxide, a molar percentage of element M in the first lithium nickel composite oxide is 0.1% to 20%.

In some embodiments, based on the total molar mass of element Ni, element Co, element Mn, and element M in the first lithium nickel composite oxide, a molar percentage of element R in the first lithium nickel composite oxide is 1% to 10%.

In some embodiments, based on the total molar mass of element Ni, element Co, element Mn, and element M in the first lithium nickel composite oxide, a molar percentage of element Ni in the first lithium nickel composite oxide is greater than or equal to 50%.

In some embodiments, the first lithium nickel composite oxide includes $Li_{x1}Na_{w1}Ni_{y1}Co_{z1}Mn_{k1}M_{q1}O_{2\pm a}R_a$, where $0.2 \leq x1 \leq 1.2$, $0.5 \leq y1 \leq 1$, $0 \leq z1 \leq 0.5$, $0 \leq k1 \leq 0.5$, $0 \leq q1 \leq 0.2$, $0.01 \leq w1 \leq 0.1$, and $0 \leq a \leq 0.1$.

In some embodiments, the positive electrode material further includes second monocrystalline particles, and the second monocrystalline particle has a second length-diameter ratio $L_2$, where $L_2$ satisfies $1 \leq L_2 < 2$; and a quantity of the first monocrystalline particles is Ni, and a quantity of the second monocrystalline particles is $N_2$, where $N_1/(N_1 + N_2)$ ranges from 20% to 50%, and $N_2/(N_1 + N_2)$ ranges from 50% to 80%. The quantity Ni of the first monocrystalline particles and the quantity $N_2$ of the second monocrystalline particles being controlled within the foregoing ranges is conducive to mutual intercalation and close packing of the first monocrystalline particles and the second monocrystalline particles, thereby increasing the energy density of the electrochemical apparatus. In addition, the second monocrystalline particle with a low length-diameter ratio can reduce defects caused by great lattice stress of the first monocrystalline particle with a high length-diameter ratio after compaction, thereby improving the high-temperature cycling and storage performance of the electrochemical apparatus.

In some embodiments, the second monocrystalline particle includes a second lithium nickel composite oxide.

In some embodiments, the second lithium nickel composite oxide contains element Ni, element Na, optionally element Co, optionally element Mn, optionally element M', and optionally element R', where element M' includes at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and element R' includes at least one of P, F, or N.

In some embodiments, based on a total molar mass of element Ni, element Co, element Mn, and element M' in the second lithium nickel composite oxide, a molar percentage of element Na in the second lithium nickel composite oxide is 1% to 10%.

In some embodiments, based on the total molar mass of element Ni, element Co, element Mn, and element M' in the second lithium nickel composite oxide, a molar percentage of element M' in the second lithium nickel composite oxide is 0.1% to 20%.

In some embodiments, based on the total molar mass of element Ni, element Co, element Mn, and element M' in the second lithium nickel composite oxide, a molar percentage of element R' in the second lithium nickel composite oxide is 1% to 10%.

In some embodiments, based on the total molar mass of element Ni, element Co, element Mn, and element M' in the second lithium nickel composite oxide, a molar percentage of element Ni in the second lithium nickel composite oxide is greater than or equal to 50%.

In some embodiments, the second lithium nickel composite oxide includes $Li_{x2}Na_{w2}Ni_{y2}Co_{z2}Mn_{k2}M'_{q2}O_{2\pm b}R'_b$, where $0.2 \leq x2 \leq 1.2$, $0.5 \leq y2 \leq 1$, $0 \leq z2 \leq 0.5$, $0 \leq k2 \leq 0.5$, $0 \leq q2 \leq 0.2$, $0.01 \leq w2 \leq 0.1$, and $0 \leq b \leq 0.1$.

In some embodiments, an average particle size $D_2$ of the second monocrystalline particle is 2 $\mu$m to 8 $\mu$m.

In some embodiments, 9 $\mu$m $\leq D_v50 \leq$ 20 $\mu$m, where $D_v50$ is a particle size of the positive electrode material at 50% in the cumulative volume distribution.

In some embodiments, $(D_v90 - D_v10)/D_v50 \leq 2$, where $D_v90$ is a particle size of the positive electrode material at 90% in the cumulative volume distribution, $D_v10$ is a particle size of the positive electrode material at 10% in the cumulative volume distribution, and $D_v50$ is a particle size of the positive electrode material at 50% in the cumulative volume distribution.

In some embodiments, a full width at half maximum FWHM (003) of a peak (003) within a range of 18° to 19.2° in an XRD diffraction pattern of the positive electrode material satisfies $0.14° \leq FWHM(003) \leq 0.2°$. FWHM(003) being within the foregoing range results in high regularity of active crystal planes for lithium intercalation and deintercalation in the lithium nickel composite oxide. This facilitates intercalation and deintercalation of lithium ions inside the lithium nickel composite oxide, thereby increasing the energy density of the electrochemical apparatus. In addition, this can improve structural stability of the active crystal planes and suppress phase change of a crystal structure and interface side reactions of the active crystal planes, thereby improving the cycling performance and storage performance of the electrochemical apparatus at high voltage and high temperature.

In some embodiments, a lattice parameter a of the positive electrode material satisfies $2.87Å \leq a \leq 2.90Å$, and a lattice parameter c of the positive electrode material satisfies $14.17Å \leq c \leq 14.21Å$. In this case, the lithium nickel composite oxide has a stable layered structure and good orderliness, which leads to the improved cycling performance and storage performance of the electrochemical apparatus at high voltage and high temperature.

In some embodiments, the positive electrode material includes a Li layer and an O layer, and an interlayer spacing between the Li layer and the O layer ranges from 2.65Å to 2.77Å.The Li-O interlayer spacing being within the foregoing range can facilitate intercalation and deintercalation of the lithium ions, thereby increasing the energy density of the electrochemical apparatus.

According to a second aspect, this application provides an electrochemical apparatus including the foregoing positive electrode material.

According to a third aspect, this application provides an electronic device including the foregoing electrochemical apparatus.

In this application, the positive electrode material includes the first monocrystalline particle having the first length-diameter ratio $L_1$, and a high length-diameter ratio of the first monocrystalline particle is conducive to reducing the active crystal planes which cause the side reactions on the surface of the positive electrode material, and suppressing the structural phase change and interface side reactions of the positive electrode material, which leads to the improved cycling performance and storage performance of the electrochemical apparatus at high voltage and high temperature.

## BRIEF DESCRIPTION OF DRAWINGS

To describe the technical solutions in some embodiments of this application more clearly, the following briefly describes the accompanying drawings required for describing some embodiments. Apparently, the accompanying drawings in the following descriptions show only some embodiments of this application, and persons skilled in the art may still derive other drawings from these accompanying drawings.

FIG. 1 is a SEM image of positive electrode material powder in Example 7 of this application;
FIG. 2 is a SEM image of a surface of a first monocrystalline particle having a first crack in Example 7 of this application;
FIG. 3 is an XRD diffraction pattern of a positive electrode material in Example 7 of this application;
FIG. 4 is a SEM image of a cross section of the positive electrode material in Example 7 of this application;
FIG. 5 is a SEM-EDX distribution diagram of element Ni on the cross section in FIG. 4;
FIG. 6 is a SEM-EDX distribution diagram of element Co on the cross section in FIG. 4; and
FIG. 7 is a SEM-EDX distribution diagram of element Na on the cross section in FIG. 4.

## DETAILED DESCRIPTION OF EMBODIMENTS

Embodiments of this application are described in detail below. Some embodiments described herein are illustrative and used to provide a basic understanding of this application. Some embodiments of this application should not be construed as any limitation on this application.

In addition, quantities, ratios, and other values are sometimes presented in the format of range in this specification. It should be understood that such format of range is used for convenience and simplicity and should be flexibly understood as including not only values explicitly designated as falling within the range but also all individual values or sub-ranges covered by the range as if each value and sub-range are explicitly designated.

In specific embodiments and claims, a list of items connected by the terms "at least one of", "at least one piece of", and "at least one kind of" or other similar terms may mean any combination of the listed items. For example, if items A and B are listed, the phrase "at least one of A or B" means only A, only B, or A and B. In another example, if items A, B, and C are listed, the phrase "at least one of A, B, or C" means only A, only B, only C, A and B (exclusive of C), A and C (exclusive of B), B and C (exclusive of A), or all of A, B, and C. The item A may include a single element or a plurality of elements. The item B may include a single element or a plurality of elements. The item C may include a single element or a plurality of elements.

This application provides a positive electrode material. The positive electrode material includes first monocrystalline particles, and the first monocrystalline particle has a first length-diameter ratio $L_1$, where $L_1$ satisfies $2 \leq L_1 \leq 5$. The first length-diameter ratio is a ratio of a long diameter and a short diameter of the first monocrystalline particle, the long diameter of the first monocrystalline particle is the longest diameter of the first monocrystalline particle in an electron microscope image, that is, a distance between two edge points farthest away from each other, and the short diameter of the first monocrystalline particle is a distance between two edge points on a perpendicular bisector of the long diameter in the electron microscope image. The positive electrode material includes the first monocrystalline particle having the first length-diameter ratio $L_1$, and a high length-diameter ratio of the first monocrystalline particle is conducive to reducing active crystal planes which cause side reactions on a surface of the positive electrode material, and suppressing structural phase change and interface side reactions of the positive electrode material, which leads to improved cycling performance and storage performance of an electrochemical apparatus at high voltage and high temperature.

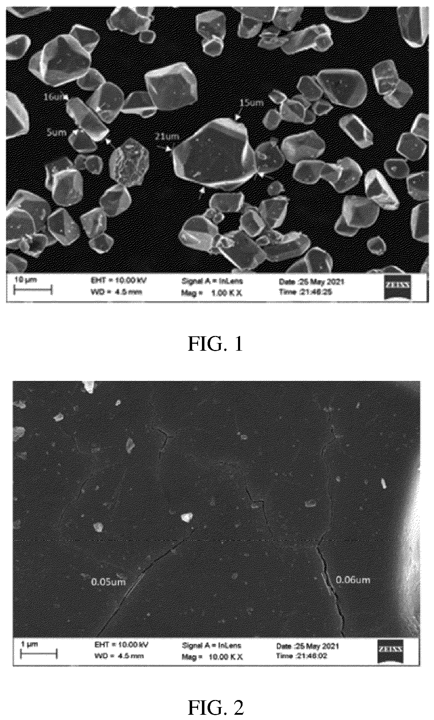

In some embodiments, the surface of the first monocrystalline particle has a first crack. The crack on the surface of the first monocrystalline particle can allow the first monocrystalline particle to have a larger specific surface area, so as to facilitate intercalation and deintercalation of lithium ions inside the first monocrystalline particle, thereby increasing energy density of the electrochemical apparatus. In addition, due to the high length-diameter ratio of the first monocrystalline particle, great stress and strain are generated by expansion and contraction caused by lithium intercalation and deintercalation in a length-diameter direction. Expansion and contraction of the first monocrystalline particle in the length-diameter direction can be buffered through the crack on the surface of the first monocrystalline particle, reducing the risk of breaking of the first monocrystalline particle, thereby improving the cycling performance and storage performance of the electrochemical apparatus at high voltage and high temperature. FIG. 2 is a SEM image of a surface of a first monocrystalline particle having a first crack in an example of this application. It can be learned from FIG. 2 that the surface of the first monocrystalline particle has a plurality of first cracks, where a width of one of the first cracks is 0.05 $\mu$m, and a width of another first crack is 0.06 $\mu$m.

In some embodiments, a wall surface of the first crack includes at least one of element P, element F, or element N. A surface layer of the wall surface inside the first crack including at least one of element P, element F, or element N can improve stability of a crystal structure of the first monocrystalline particle at the first crack and suppress phase change of the crystal structure and interface side reactions at the first crack, thereby improving the cycling performance and storage performance of the electrochemical apparatus at high voltage and high temperature.

In some embodiments, a width h of the first crack is less than or equal to 0.1 $\mu$m. For example, the first crack is an irregular crack, and the maximum width of the irregular crack is 0.1 $\mu$m. The width of the first crack being less than or equal to 0.1 $\mu$m is conducive to suppressing the interface side reactions, thereby improving the cycling performance and storage performance of the electrochemical apparatus at high voltage and high temperature.

In some embodiments, a percentage of a depth of the first crack to a particle size of the first monocrystalline particle is less than or equal to 10%, so as to suppress the interface side reactions, thereby improving the cycling performance and storage performance of the electrochemical apparatus at high voltage and high temperature. The particle size of the first monocrystalline particle is the longest diameter of a cross section of the first monocrystalline particle.

In some embodiments, an average particle size $D_1$ of the first monocrystalline particle is 10 $\mu$m to 25 $\mu$m.

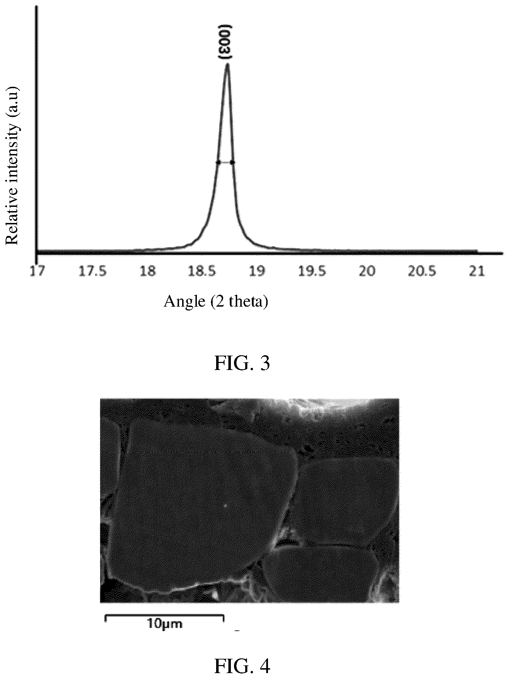

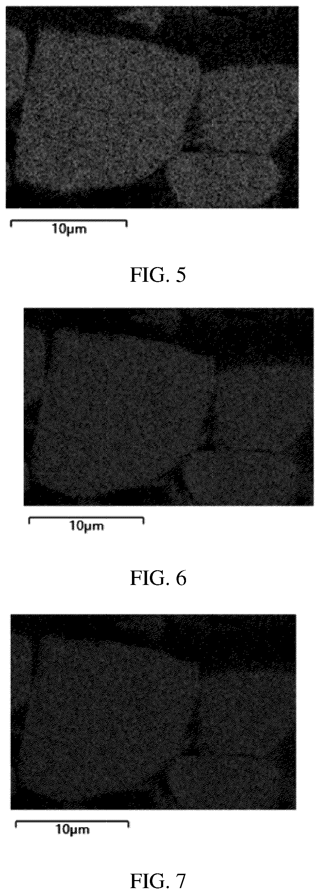

In some embodiments, the first monocrystalline particle includes a first lithium nickel composite oxide. In some embodiments, the first lithium nickel composite oxide contains element Ni, element Na, optionally element Co, optionally element Mn, optionally element M, and optionally element R, where element M includes at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and element R includes at least one of P, F, or N. In some embodiments, the first lithium nickel composite oxide contains element Ni and element Co. FIG. 4 is a SEM image of a cross section of the positive electrode material in an example (that is, subsequent Example 7) of this application; FIG. 5 is a SEM-EDX distribution diagram of element Ni on the cross section in FIG. 4; and FIG. 6 is a SEM-EDX distribution diagram of element Co on the cross section in FIG. 4.

In some embodiments, based on a total molar mass of element Ni, element Co, element Mn, and element M in the first lithium nickel composite oxide, a molar percentage of element Na in the first lithium nickel composite oxide is 1% to 10%. FIG. 7 is a SEM-EDX distribution diagram of element Na on the cross section in FIG. 4.

In some embodiments, based on the total molar mass of element Ni, element Co, element Mn, and element M in the first lithium nickel composite oxide, a molar percentage of element M in the first lithium nickel composite oxide is greater than or equal to 0.1% to 20%.

In some embodiments, based on the total molar mass of element Ni, element Co, element Mn, and element M in the first lithium nickel composite oxide, a molar percentage of element R in the first lithium nickel composite oxide is greater than or equal to 1% and less than or equal to 10%.

In some embodiments, based on the total molar mass of element Ni, element Co, element Mn, and element M in the first lithium nickel composite oxide, a molar percentage of element Ni in the first lithium nickel composite oxide is greater than or equal to 50%.

Doping the foregoing element Na, element M, or element R can adjust surface energy of the positive electrode material, improve sintering activity of the material, facilitate growth of particle size during sintering, reduce activity of side reactions on the surface of the material, and improve stability of the surface of the material, thereby suppressing oxygen release and gas production of the positive electrode material in high-temperature cycling. In addition, doping elements with a large ion radius in a lithium layer can increase an interlayer spacing between the lithium layer and an oxygen layer, thereby improving kinetic performance of the positive electrode material.

Specifically, in some embodiments, the first lithium nickel composite oxide includes $Li_{x1}Na_{w1}Ni_{y1}Co_{z1}Mn_{k1}M_{q1}O_{2\pm a}R_a$, where $0.2 \leq x1 \leq 1.2$, $0.5 \leq y1 \leq 1$, $0 \leq z1 \leq 0.5$, $0 \leq k1 \leq 0.5$, $0 < q1 \leq 0.2$, $0.01 \leq w1 \leq 0.1$, and $0 \leq a \leq 0.1$, M includes at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and R includes at least one of P, F, or N.

In some embodiments, the positive electrode material further includes second monocrystalline particles, and the second monocrystalline particle has a second length-diameter ratio $L_2$, where $L_2$ satisfies $1 \leq L_2 < 2$. The second length-diameter ratio is a ratio of a long diameter and a short diameter of the second monocrystalline particle, the long diameter of the second monocrystalline particle is the longest diameter of the second monocrystalline particle in an electron microscope image, that is, a distance between two edge points farthest away from each other, and the short diameter of the second monocrystalline particle is a distance between two edge points on a perpendicular bisector of the long diameter in the electron microscope image. FIG. 1 is a scanning electron microscope (SEM) image of positive electrode material powder in an example (that is, subsequent Example 7) of this application.

In some embodiments, a quantity of the first monocrystalline particles is $N_1$, and a quantity of the second monocrystalline particles is $N_2$, where $N_1/(N_1 + N_2)$ ranges from 20% to 50%, and $N_2/(N_1 + N_2)$ ranges from 50% to 80%. The second monocrystalline particle has a low length-diameter ratio, such that a path for intercalation and deintercalation of lithium ions in the second monocrystalline particle is short, thereby improving the kinetic performance of the positive electrode material. In addition, the quantity $N_1$ of the first monocrystalline particles and the quantity $N_2$ of the second monocrystalline particles being controlled within the foregoing ranges is conducive to mutual intercalation and close packing of the first monocrystalline particles and the second monocrystalline particles, thereby increasing the energy density of the electrochemical apparatus. In addition, the second monocrystalline particle with a low length-diameter ratio can reduce defects caused by great lattice stress of the first monocrystalline particle with a high length-diameter ratio after compaction, thereby improving the high-temperature cycling and storage performance of the electrochemical apparatus. Typically but not limitedly, $N_1/(N_1 + N_2)$ may be 20%, 25%, 30%, 35%, 40%, 45%, or 50%, or falls within a range defined by any two of these point values and any value in the range; and $N_2/(N_1 + N_2)$ may be 50%, 55%, 60%, 65%, 70%, 75%, or 80%, or falls within a range defined by any two of these point values and any value in the range.

In some embodiments, the second monocrystalline particle includes a second lithium nickel composite oxide. In some embodiments, the second lithium nickel composite oxide contains element Ni, element Na, optionally element Co, optionally element Mn, optionally element M', and optionally element R', where element M' includes at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and element R' includes at least one of P, F, or N.

In some embodiments, based on a total molar mass of element Ni, element Co, element Mn, and element M' in the second lithium nickel composite oxide, a molar percentage of element Na in the second lithium nickel composite oxide is 1% to 10%.

In some embodiments, based on the total molar mass of element Ni, element Co, element Mn, and element M' in the second lithium nickel composite oxide, a molar percentage of element M' in the second lithium nickel composite oxide is 0.1% to 20%.

In some embodiments, based on the total molar mass of element Ni, element Co, element Mn, and element M' in the second lithium nickel composite oxide, a molar percentage of element R' in the second lithium nickel composite oxide is 1% to 10%.

In some embodiments, based on the total molar mass of element Ni, element Co, element Mn, and element M' in the second lithium nickel composite oxide, a molar percentage of element Ni in the second lithium nickel composite oxide is greater than or equal to 50%.

In some embodiments, the second lithium nickel composite oxide includes $Li_{x2}Na_{w2}Ni_{y2}Co_{z2}Mn_{k2}M'_{q2}O_{2\pm b}R'_b$, where $0.2 \leq x2 \leq 1.2$, $0.5 \leq y2 \leq 1$, $0 \leq z2 \leq 0.5$, $0 \leq k2 \leq 0.5$, $0 \leq q2 \leq 0.2$, $0.01 \leq w2 \leq 0.1$, and $0 \leq b \leq 0.1$, M' includes at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and R' includes at least one of P, F, or N.

In some embodiments, an average particle size $D_2$ of the second monocrystalline particle is 2 $\mu$m to 8 $\mu$m.

In some embodiments, 9 $\mu$m $\leq D_v50 \leq$ 20 $\mu$m, where $D_v50$ is a particle size of the positive electrode material at 50% in the cumulative volume distribution.

In some embodiments, $(D_v90 - D_v10)/D_v50 \leq 2$, where $D_v90$ is a particle size of the positive electrode material at 90% in the cumulative volume distribution, $D_v10$ is a particle size of the positive electrode material at 10% in the cumulative volume distribution, and $D_v50$ is a particle size of the positive electrode material at 50% in the cumulative volume distribution. The foregoing relationship being satisfied can prevent an excessively small compacted density of the positive electrode material caused by an excessively wide particle size distribution range of the particles of the positive electrode material.

In some embodiments, a full width at half maximum FWHM(003) of a peak (003) within a range of 18° to 19.2° in an XRD diffraction pattern of the positive electrode material satisfies $0.14° \leq$ FWHM(003) $\leq 0.2°$. FWHM(003) being within the foregoing range results in high regularity of active crystal planes for lithium intercalation and deintercalation in the lithium nickel composite oxide. This facilitates intercalation and deintercalation of lithium ions inside the lithium nickel composite oxide, thereby increasing the energy density of the electrochemical apparatus. In addition, this can improve structural stability of the active crystal planes and suppress phase change of a crystal structure and interface side reactions of the active crystal planes, thereby improving the cycling performance and storage performance of the electrochemical apparatus at high voltage and high temperature. FIG. 3 is an XRD diffraction pattern of a positive electrode material in an example (that is, subsequent Example 7) of this application. The full width at half maximum FWHM of the peak (003) of the positive electrode material within the range of 18° to 19.2° is 0.152°.

In some embodiments, a lattice parameter a of the positive electrode material satisfies 2.87Å $\leq$ a $\leq$ 2.90Å, and a lattice parameter c of the positive electrode material satisfies 14.17Å $\leq$ c $\leq$ 14.21Å. In this case, the lithium nickel composite oxide has a stable layered structure and good orderliness, which leads to the improved cycling performance and storage performance of the electrochemical apparatus at high voltage and high temperature.

In some embodiments, the positive electrode material includes a Li layer and an O layer, and an interlayer spacing between the Li layer and the O layer ranges from 2.65Å to 2.77Å. The Li-O interlayer spacing being within the foregoing range can facilitate intercalation and deintercalation of the lithium ions, thereby increasing the energy density of the electrochemical apparatus.

An embodiment of this application further provides an electrochemical apparatus including a positive electrode plate, a negative electrode plate, a separator, an electrolyte, and an outer package.

The positive electrode plate includes a positive electrode current collector and a positive electrode active layer. The positive electrode active layer is disposed on at least one surface of the positive electrode current collector, and the positive electrode active layer includes the foregoing positive electrode material. The positive electrode current collector of this application is not particularly limited, and may be any well-known positive electrode current collector in the art, for example, aluminum foil, aluminum alloy foil, or a composite current collector.

The positive electrode active layer further includes a conductive agent and a binder. A material of the conductive agent is not limited in this application, for example, the material of the conductive agent includes but is not limited to at least one of carbon nanotubes, carbon fibers, conductive carbon black, acetylene black, graphene, or Ketjen black. A material of the binder is not limited in this application, for example, the material of the binder includes but is not limited to at least one of polyvinylidene fluoride, vinylidene fluoride-hexafluoropropylene copolymer, polyamide, polyacrylonitrile, polyacrylic ester, polyacrylic acid, polyacrylic salt, sodium carboxymethyl cellulose, polyvinylpyrrolidone, polyvinyl ether, polymethyl methacrylate, polytetrafluoroethylene, polyhexafluoropropylene, or styrene-butadiene rubber. During preparation of positive electrode plate, the binder, the conductive agent, and the positive electrode material are added into a solvent and mixed well to obtain a positive electrode slurry. The positive electrode slurry is applied on a surface of the positive electrode current collector, followed by drying and then rolling, to obtain the positive electrode active layer. A compacted density of the positive electrode active layer is greater than or equal to 3.5 g/cc.

The negative electrode plate includes a negative electrode current collector and a negative electrode active layer. The negative electrode active layer is disposed on at least one surface of the negative electrode current collector, and the negative electrode active layer includes a negative electrode material. The negative electrode plate of this application is not particularly limited. The negative electrode material may be any negative electrode material in the prior art, and the negative electrode material includes at least one of graphite, hard carbon, soft carbon, silicon, or a silicon-carbon or silicon oxide. The negative electrode current collector may be any well-known negative electrode current collector in the art, for example, copper foil, aluminum foil, aluminum alloy foil, or a composite current collector.

The separator of this application is not particularly limited, for example, the separator may be made of a material stable to the electrolyte of this application, so that ions in the electrolyte can pass through the separator to move between the positive electrode plate and the negative electrode plate. For example, the material of the separator may include polyethylene (PE) and the like.

The separator is disposed between the positive electrode plate and the negative electrode plate. The negative electrode plate, the separator, and the positive electrode plate may be stacked sequentially along a thickness direction of the negative electrode plate or wound, and accommodated in an inner space of the outer package.

The electrolyte of this application is not particularly limited, and any well-known electrolyte in the art can be used. The electrolyte may be in any one of a gel state, a solid state, and a liquid state. When the electrolyte is a liquid electrolyte, the liquid electrolyte includes a lithium salt and a non-aqueous solvent. The lithium salt is not particularly limited, and any well-known lithium salt in the art can be used, provided that the objectives of this application can be achieved. For example, the lithium salt may be at least one of LiTFSI, $LiPF_6$, $LiBF_4$, $LiAsF_6$, $LiClO_4$, $LiB(C_6H_5)_4$, $LiCH_3SO_3$, $LiCF_3SO_3$, $EiN(SO_2CF_3)_2$, $LiC(SO_2CF_3)_3$, or $LiPO_2F_2$. The non-aqueous solvent is not particularly limited, provided that the objectives of this application can be achieved. For example, the non-aqueous solvent may be at least one of a carbonate compound, a carboxylate compound, an ether compound, a nitrile compound, or another organic solvent. The carbonate compound may include at least one of diethyl carbonate (DEC), dimethyl carbonate (DMC), dipropyl carbonate (DPC), methyl propyl carbonate (MPC), ethyl propyl carbonate (EPC), ethyl methyl carbonate (MEC), ethylene carbonate (EC), propylene carbonate (PC), butylene carbonate (BC), vinyl ethylene carbonate (VEC), fluoroethylene carbonate (FEC), 1,2-difluoroethylene carbonate, 1,1-difluoroethylene carbonate, 1,1,2-trifluoroethylene carbonate, 1,1,2,2-tetrafluoroethylene carbonate, 1-fluoro-2-methylethylene carbonate, 1-fluoro-1-methylethylene carbonate, 1,2-difluoro-1-methylethylene carbonate, 1,1,2-trifluoro-2-methylethylene carbonate, or trifluoromethylethylene carbonate.

The electrochemical apparatus further includes a positive tab and a negative tab. The positive tab is electrically connected to the positive electrode current collector, and the negative tab is electrically connected to the negative electrode current collector. Both the positive tab and the negative tab are led out of the outer package, configured to be electrically connected to an external circuit for charging and discharging the electrochemical apparatus, and configured for monitoring an internal working state of the electrochemical apparatus.

This application further provides an electronic apparatus, where the electronic apparatus includes the foregoing electrochemical apparatus.

The electronic apparatus in some embodiments of this application is not particularly limited, and may be any known electronic apparatus used in the prior art. In some embodiments, the electronic apparatus includes but is not limited to a notebook computer, a pen-input computer, a mobile computer, an electronic book player, a portable telephone, a portable fax machine, a portable copier, a portable printer, a stereo headset, a video recorder, a liquid crystal television, a portable cleaner, a portable CD player, a mini-disc, a transceiver, an electronic notebook, a calculator, a storage card, a portable recorder, a radio, a standby power source, a motor, an automobile, a motorcycle, a motor bicycle, a bicycle, a lighting appliance, a toy, a game console, a clock, an electric tool, a flash lamp, a camera, a large household battery, or a lithium-ion capacitor.

The following further describes this application in detail with reference to specific examples by using an example in which the electrochemical apparatus is a lithium-ion battery.

I. Lithium-ion battery performance test methods

(1) Morphology and particle percentage in number test: A Carl Zeiss ZEISS SIGMA-500 field emission scanning electron microscope was used to perform morphology observation and crack width, average particle size, and length-diameter ratio tests on samples. A SEM image was photographed at an appropriate factor to observe whether there is a crack on the surface of a first monocrystalline particle. Image processing software was used to randomly count the maximum widths of cracks on surfaces of 10 first monocrystalline particles, with an average value thereof taken as a width h of the crack on the surface of the first monocrystalline particle; randomly count the longest diameters and length-diameter ratios of 50 first monocrystalline particles, with an average value of the longest diameters and an average value of the length-diameter ratios taken as an average particle size $D_1$ and a length-diameter ratio $L_1$ of the first monocrystalline particle respectively; randomly count the longest diameters and length-diameter ratios of 50 second monocrystalline particles, with an average value of the longest diameters and an average value of the length-diameter ratios taken as an average particle size $D_2$ and a length-diameter ratio $L_2$ of the second monocrystalline particle respectively; and randomly count length-diameter ratios of 100 particles to determine a total quantity of first monocrystalline particles and a total quantity of second monocrystalline particles, so as to obtain respective percentages.

(2) Element type and percentage test: Respective element types and percentages of the first monocrystalline particle and the second monocrystalline particle in the positive electrode material were tested by using a SEM-EDX. An overall element type and percentage of the positive electrode material was tested by using an inductively coupled plasma emission spectrometer (ICP). For an element type at a wall surface of the crack, the positive electrode material was transferred to a chamber of a scanning electron microscope (model: FEI Vion Plasma FIB) provided with a focused ion beam and processed to obtain a sample for analysis by a scanning transmission electron microscope (STEM, model: FEI Titan3 G2 60-300). It was required that a surface of the sample was protected with Pt and processed with a Ga ion beam, a thickness of the sample did not exceed 100 nm, and cleaning was performed in a low voltage mode to remove the residual surface of the processed sample. The sample was observed under the STEM, and data at the wall surface of the crack was collected using an EDX function at an appropriate factor to determine the element type at the wall surface of the crack.

(3) XRD test: A surface of the sample of the positive electrode material was kept flat, and the sample was placed on the sample stage of an XRD test instrument (model: Bruker, D8), with a scanning rate of 2°/min and a scanning angle within a range of 10° to 90°, to obtain an XRD pattern.

(4) Particle size test: A laser particle size analyzer was used for the test to obtain distribution by volume of the positive electrode material, to obtain $D_v10$, $D_v50$, and $D_v90$ of the positive electrode material.

(5) Capacity loss rate and thickness swelling rate after storage at 60°C for 7 days: At 25°C, the lithium-ion battery was charged to 4.35 V at a constant current of 0.2C to reach a fully charged state (100% SOC), and then discharged to 2.8 V at a constant current of 0.2C to reach a fully discharged state. A discharge capacity at that time was recorded as an initial capacity. The foregoing charging process was repeated to make the lithium-ion battery reach a fully charged state (100% SOC), and a micrometer was used to measure a thickness of the lithium-ion battery at that time as H0. The lithium-ion battery was stored in a 60°C oven for 7 days and then cooled to 25°C, and subsequently the micrometer was used to measure a thickness of the lithium-ion battery at that time as H1. Then, the foregoing charging and discharging process was repeated for 3 times at a current of 0.2C at 25°C, and a discharge capacity of the lithium-ion battery in the third process was measured and recorded as a recovered capacity after standing.

Capacity loss rate = (initial capacity - recovered capacity after standing)/initial capacity × 100%.

$$\text{Thickness swelling rate} = (H1 - H0)/H0 \times 100\%.$$

(6) Button cell test: A positive electrode active layer on a surface of a positive electrode plate was cleaned with N-methylpyrrolidone (NMP), dried in vacuum at 85°C for 2 h, and then punched into wafers required for a 2025 button cell. Nickel foam, a lithium sheet, a separator, and a positive electrode wafer were assembled sequentially into a button cell, and 50 microliters of electrolyte was injected. A composition of the electrolyte was that a mass ratio of EC:PC:DEC = 1:1:1, and a mass concentration of $LiPF_6$ in the electrolyte was 12.5%.

At 25°C, the assembled button cell was charged and discharged at a current of 0.2C at a cut-off voltage of 2.7 V to 4.3 V, and a gram capacity of the button cell was measured. Gram capacity = discharge capacity/mass of positive electrode material.

(7) High-temperature cycle capacity retention rate test: At 45°C, the lithium-ion battery was charged to 4.35 V at a constant current of 0.5C and then discharged to 2.8 V at a constant current of 1C. After 500 cycles, a ratio of power discharged at the 500th discharging and an initial discharge capacity was calculated as a high-temperature cycle capacity retention rate.

II. Preparation method of lithium-ion battery

In the following examples, a chemical formula of a nickel-containing hydroxide precursor was $Ni_yCo_zMn_k(OH)_2$, where raw materials of element M being Sr, Y, Ti, Zr, Nb, Al, and B were respectively present as $SrCO_3$, $Y_2O_3$, $TiO_2$, $ZrO_2$, $Nb_2O_5$, $Al_2O_3$, and $H_3BO_3$, and a raw material of element R being F was present as $NH_4F$.

(1) Preparation of positive electrode material

(1a) Preparation of sodium precursor

The nickel-containing hydroxide precursor, sodium carbonate, optionally element source M, and optionally element source R were weighed and mixed to obtain a primary mixture. A molar ratio of element Na and metal elements other than Na was 1.05:1, and percentages of the metal elements other than Na were made according to Table 1. The primary mixture was subjected to primary sintering to obtain a sodium precursor. For primary sintering temperature, refer to Table 1. A primary sintering duration was 12 h.

(1b) Ion exchange

The sodium precursor and lithium carbonate were weighed and mixed to obtain a secondary mixture. A ratio of a molar mass of element sodium in the sodium precursor and a molar mass of element lithium in lithium carbonate was 1:10. The secondary mixture was subjected to secondary sintering to obtain a primary product. For secondary sintering temperature, refer to Table 1. A secondary sintering duration was 6 h. After cooling, the primary product was placed into deionized water at a liquid-solid ratio of 1:1 to be washed for 10 min, followed by solid-liquid separation and then drying, to obtain a positive electrode material in which first monocrystalline particles and second monocrystalline particles were mixed.

Example 21 differs from Example 4 in that in the step of ion exchange, lithium nitrate was used to replace lithium carbonate to facilitate agglomeration and growth of small particles and select to obtain a positive electrode material including only first monocrystalline particles.

(3) Preparation of positive electrode plate

The positive electrode material, a conductive agent conductive carbon black (Super P), and a binder polyvinylidene fluoride (PVDF) were mixed at a mass ratio of 98:1:1, then an appropriate amount of N-methylpyrrolidone (NMP) was added as a solvent, and the resulting mixture was fully stirred and mixed well to obtain a positive electrode slurry with a solid content of 75%. Then, the positive electrode slurry was uniformly applied onto one surface of a positive electrode current collector aluminum foil, and dried at 80°C. The foregoing steps were repeated on another surface of the aluminum foil to obtain a positive electrode plate with two surfaces coated, followed by cold pressing and cutting, to obtain a positive electrode plate.

(4) Preparation of separator

A polyethylene (PE) porous polymer film was used as a separator.

(5) Preparation of negative electrode plate

A negative electrode material artificial graphite, a binder styrene-butadiene rubber, and a thickener sodium carboxymethyl cellulose (CMC) were fully stirred and mixed at a mass ratio of 96:2:2 in an appropriate amount of deionized water to form a uniform negative electrode slurry. The negative electrode slurry was uniformly applied onto one surface of a negative electrode current collector copper foil, and dried. The foregoing steps were repeated on another surface of the copper foil to obtain a negative electrode plate with two surfaces coated, followed by uniform applying, cold pressing, and cutting, to obtain a negative electrode plate.

(6) Preparation of lithium-ion battery

The prepared positive electrode plate, separator, and negative electrode plate were stacked in sequence so that the separator was sandwiched between the positive electrode plate and the negative electrode plate for separation, and the stack was wound to obtain a bare cell. The bare cell was placed in an outer package aluminum-plastic film, with an electrolyte injection opening left. The electrolyte was injected from the electrolyte injection opening (a composition of the electrolyte was that a mass ratio of EC:PC:DEC = 1:1:1, and a mass concentration of $LiPF_6$ in the electrolyte was 12.5%), followed by processes such as vacuum packaging, standing, formation, and shaping, to complete preparation of lithium-ion battery.

Comparative Example 1

A nickel-containing hydroxide precursor and lithium hydroxide were weighed and mixed to obtain a primary mixture. A molar ratio of element Li and metal elements other than Li was 1.05:1. The primary mixture was subjected to primary sintering to obtain a positive electrode material. For primary sintering temperature, refer to Table 1. A primary sintering duration was 12 h.
Molar percentages of the elements in the positive electrode materials and the sintering temperatures in the examples and Comparative Example 1 are shown in Table 1. The molar percentages of the elements are calculated given that a total molar mass of elements Ni, Co, Mn, and M is 100%.

**Table 1**

| Examples | Li | Na | Ni | Co | Mn | Sr | Y | Ti | Zr | Nb | Al | B | F | Primary sintering temperature | Secondary sintering temperature |
|---|---|---|---|---|---|---|---|---|---|---|---|---|---|---|---|
| Unit | mol% | mol % | mol% | mol % | mol % | mol % | mol % | mol % | mol % | mol % | mol % | mol % | mol % | °C | °C |
| Comparative Example 1 | 100 | / | 98.50 | 1.50 | 0.00 | 0.00 | 0.00 | 0.00 | 0.00 | 0.00 | 0.00 | 0.00 | 0.00 | 1000 | / |
| Example 1 | 98.93 | 1.07 | 98.39 | 1.61 | 0.00 | 0.00 | 0.00 | 0.00 | 0.00 | 0.00 | 0.00 | 0.00 | 0.00 | 550 | 275 |
| Example 2 | 98.95 | 1.05 | 98.33 | 1.67 | 0.00 | 0.00 | 0.00 | 0.00 | 0.00 | 0.00 | 0.00 | 0.00 | 0.00 | 600 | 275 |
| Example 3 | 98.96 | 1.04 | 98.41 | 1.59 | 0.00 | 0.00 | 0.00 | 0.00 | 0.00 | 0.00 | 0.00 | 0.00 | 0.00 | 650 | 275 |
| Example 4 | 98.62 | 1.38 | 98.42 | 1.58 | 0.00 | 0.00 | 0.00 | 0.00 | 0.00 | 0.00 | 0.00 | 0.00 | 0.00 | 700 | 275 |
| Example 5 | 98.90 | 1.10 | 98.46 | 0.60 | 0.94 | 0.00 | 0.00 | 0.00 | 0.00 | 0.00 | 0.00 | 0.00 | 0.00 | 750 | 275 |
| Example 6 | 98.96 | 1.04 | 98.64 | 0.42 | 0.00 | 0.94 | 0.00 | 0.00 | 0.00 | 0.00 | 0.00 | 0.00 | 0.00 | 800 | 275 |
| Example 7 | 98.95 | 1.05 | 98.79 | 0.22 | 0.00 | 0.00 | 0.99 | 0.00 | 0.00 | 0.00 | 0.00 | 0.00 | 0.00 | 900 | 275 |
| Example 8 | 98.92 | 1.08 | 98.54 | 0.54 | 0.00 | 0.00 | 0.00 | 0.92 | 0.00 | 0.00 | 0.00 | 0.00 | 0.00 | 900 | 275 |
| Example 9 | 98.90 | 1.10 | 98.7 | 0.34 | 0.00 | 0.00 | 0.00 | 0.00 | 0.96 | 0.00 | 0.00 | 0.00 | 0.00 | 900 | 275 |
| Example 10 | 98.80 | 1.20 | 98.51 | 0.54 | 0.00 | 0.00 | 0.00 | 0.00 | 0.00 | 0.95 | 0.00 | 0.00 | 0.00 | 900 | 275 |
| Example 11 | 98.89 | 1.11 | 98.67 | 0.36 | 0.00 | 0.00 | 0.00 | 0.00 | 0.00 | 0.00 | 0.97 | 0.00 | 0.00 | 900 | 275 |
| Example 12 | 98.66 | 1.34 | 98.42 | 1.58 | 0.00 | 0.00 | 0.00 | 0.00 | 0.00 | 0.00 | 0.00 | 0.00 | 0.90 | 900 | 275 |
| Example 13 | 98.66 | 1.34 | 98.42 | 0.68 | 0.00 | 0.00 | 0.00 | 0.00 | 0.00 | 0.00 | 0.00 | 0.90 | 0.00 | 900 | 275 |
| Example 14 | 98.77 | 1.23 | 98.46 | 0.68 | 0.00 | 0.00 | 0.40 | 0.46 | 0.00 | 0.00 | 0.00 | 0.00 | 0.00 | 900 | 275 |
| Example 15 | 98.77 | 1.23 | 98.46 | 0.88 | 0.00 | 0.00 | 0.33 | 0.33 | 0.00 | 0.00 | 0.00 | 0.00 | 0.33 | 900 | 275 |
| Example 16 | 98.77 | 1.23 | 98.46 | 0.94 | 0.00 | 0.00 | 0.20 | 0.20 | 0.20 | 0.00 | 0.00 | 0.00 | 0.20 | 900 | 275 |
| Example 17 | 98.77 | 1.23 | 98.46 | 0.74 | 0.00 | 0.00 | 0.20 | 0.20 | 0.20 | 0.00 | 0.00 | 0.20 | 0.00 | 900 | 275 |
| Example 18 | 98.77 | 1.23 | 98.46 | 0.74 | 0.00 | 0.00 | 0.20 | 0.20 | 0.20 | 0.00 | 0.00 | 0.20 | 0.20 | 900 | 275 |
| Example 19 | 98.8 | 1.2 | 98.5 | 0.70 | 0.00 | 0.00 | 0.20 | 0.20 | 0.20 | 0.00 | 0.00 | 0.20 | 0.00 | 900 | 275 |
| Example 20 | 98.8 | 1.2 | 98.5 | 0.70 | 0.00 | 0.00 | 0.20 | 0.20 | 0.20 | 0.00 | 0.00 | 0.20 | 0.20 | 950 | 375 |
| Example 21 | 98.62 | 1.38 | 98.42 | 1.58 | 0.00 | 0.00 | 0.00 | 0.00 | 0.00 | 0.00 | 0.00 | 0.00 | 0.00 | 700 | 275 |

Related parameters of the first monocrystalline particles and the second monocrystalline particles in the positive electrode materials in the examples are shown in Table 2.

**Table 2**

| Examples | Length-diameter ratio $L_1$ of first monocrystalline particle | Percentage of first monocrystalline particles in number | Average particle size $D_1$ of first monocrystalline particle | Width of crack on surface of first monocrystalline particle | Length-diameter ratio $L_2$ of second monocrystalline particle | Percentage of second monocrystalline particles in number | Average particle size $D_2$ of second monocrystalline particle | FWHW(003) | a | c | Li-O interlayer spacing | Compacted density | $D_v50$ | $(D_v90 - D_v10)/D_v50$ |
|---|---|---|---|---|---|---|---|---|---|---|---|---|---|---|
| Unit | / | / | μm | μm | / | / | μm | ° | Å | Å | Å | g/cc | μm | / |
| Comparative Example 1 | / | / | / | / | 1.1 | 100% | 7 | 0.500 | 2.912 | 14.230 | 2.56 | 3.3 | 7 | 2.1 |
| Example 1 | 2.00 | 22.0% | 10 | / | 1.30 | 78% | 2 | 0.200 | 2.878 | 14.172 | 2.65 | 3.60 | 9 | 1.9 |
| Example 2 | 2.05 | 23.0% | 11 | / | 1.40 | 77% | 2.3 | 0.195 | 2.878 | 14.172 | 2.65 | 3.65 | 10 | 1.7 |

| Examples | Length-diameter ratio $L_1$ of first monocrystalline particle | Percentage of first monocrystalline particles in number | Average particle size $D_1$ of first monocrystalline particle | Width of crack on surface of first monocrystalline particle | Length-diameter ratio $L_2$ of second monocrystalline particle | Percentage of second monocrystalline particles in number | Average particle size $D_2$ of second monocrystalline particle | FWHW(003) | a | c | Li-O interlayer spacing | Compacted density | $D_v50$ | $(D_v90 - D_v10)/D_v50$ |
|---|---|---|---|---|---|---|---|---|---|---|---|---|---|---|
| Unit | / | / | μm | μm | / | / | μm | ° | Å | Å | Å | g/cc | μm | / |
| Example 3 | 2.10 | 25.0% | 12 | / | 1.44 | 75% | 2.5 | 0.184 | 2.878 | 14.172 | 2.65 | 3.70 | 11 | 1.6 |
| Example 4 | 2.20 | 29.0% | 13 | 0.02 | 1.45 | 71% | 2.8 | 0.176 | 2.877 | 14.171 | 2.65 | 3.90 | 12 | 1.5 |
| Example 5 | 2.40 | 33.0% | 13.8 | 0.03 | 1.60 | 67% | 2.9 | 0.168 | 2.877 | 14.171 | 2.65 | 3.91 | 12.2 | 1.4 |
| Example 6 | 2.50 | 40.0% | 15 | 0.05 | 1.50 | 60% | 3.1 | 0.156 | 2.877 | 14.171 | 2.66 | 3.92 | 13.8 | 1.3 |
| Example 7 | 2.60 | 33.0% | 15.3 | 0.06 | 1.11 | 67% | 3.1 | 0.152 | 2.877 | 14.171 | 2.67 | 3.93 | 14.5 | 1.1 |
| Example 8 | 2.64 | 34.0% | 15.4 | 0.06 | 1.12 | 66% | 3.3 | 0.151 | 2.883 | 14.177 | 2.68 | 3.93 | 14.6 | 1.09 |
| Example 9 | 2.70 | 33.0% | 15.4 | 0.06 | 1.20 | 67% | 3.5 | 0.153 | 2.887 | 14.180 | 2.69 | 3.93 | 16.8 | 1.08 |
| Example 10 | 2.80 | 38.0% | 16 | 0.06 | 1.21 | 62% | 3.8 | 0.152 | 2.887 | 14.181 | 2.69 | 3.99 | 15.5 | 1.05 |

| Examples | Length-diameter ratio $L_1$ of first monocrystalline particle | Percentage of first monocrystalline particles in number | Average particle size $D_1$ of first monocrystalline particle | Width of crack on surface of first monocrystalline particle | Length-diameter ratio $L_2$ of second monocrystalline particle | Percentage of second monocrystalline particles in number | Average particle size $D_2$ of second monocrystalline particle | FWHW(003) | a | c | Li-O interlayer spacing | Compacted density | $D_v50$ | $(D_v90 - D_v10)/D_v50$ |
|---|---|---|---|---|---|---|---|---|---|---|---|---|---|---|
| Unit | / | / | μm | μm | / | / | μm | ° | Å | Å | Å | g/cc | μm | / |
| Example 11 | 2.81 | 38.3% | 17 | 0.07 | 1.30 | 62% | 4.1 | 0.155 | 2.889 | 14.183 | 2.67 | 3.99 | 16.1 | 1.03 |
| Example 12 | 2.88 | 39.0% | 17.3 | 0.07 | 1.31 | 61% | 4.1 | 0.156 | 2.890 | 14.184 | 2.70 | 4.00 | 16.2 | 1.01 |
| Example 13 | 2.90 | 39.1% | 17.5 | 0.07 | 1.32 | 61% | 4.4 | 0.152 | 2.890 | 14.184 | 2.65 | 4.01 | 16.4 | 1 |
| Example 14 | 3.00 | 39.4% | 17.8 | 0.08 | 1.34 | 61% | 4.8 | 0.156 | 2.885 | 14.179 | 2.69 | 4.03 | 16.7 | 0.99 |
| Example 15 | 3.30 | 39.5% | 17.9 | 0.08 | 1.32 | 61% | 5 | 0.157 | 2.883 | 14.177 | 2.70 | 4.10 | 17 | 0.97 |
| Example 16 | 3.30 | 40.0% | 18 | 0.08 | 1.20 | 60% | 5.2 | 0.147 | 2.885 | 14.178 | 2.71 | 4.11 | 17 | 0.96 |
| Example 17 | 3.50 | 41.0% | 18 | 0.08 | 1.11 | 59% | 5.2 | 0.145 | 2.884 | 14.178 | 2.71 | 4.11 | 17 | 0.95 |
| Example 18 | 3.90 | 41.5% | 17.9 | 0.08 | 1.20 | 59% | 5.2 | 0.154 | 2.884 | 14.178 | 2.74 | 4.09 | 16 | 0.93 |

14

| Examples | Length-diameter ratio $L_1$ of first monocrystalline particle | Percentage of first monocrystalline particles in number | Average particle size $D_1$ of first monocrystalline particle | Width of crack on surface of first monocrystalline particle | Length-diameter ratio $L_2$ of second monocrystalline particle | Percentage of second monocrystalline particles in number | Average particle size $D_2$ of second monocrystalline particle | FWHW(003) | a | c | Li-O interlayer spacing | Compacted density | $D_v50$ | $(D_v90 - D_v10)/D_v50$ |
|---|---|---|---|---|---|---|---|---|---|---|---|---|---|---|
| Unit | / | / | μm | μm | / | / | μm | ° | Å | Å | Å | g/cc | μm | / |
| Example 19 | 3.92 | 42.0% | 19 | 0.09 | 1.10 | 58% | 5.5 | 0.143 | 2.885 | 14.179 | 2.75 | 4.12 | 18 | 0.9 |
| Example 20 | 4.00 | 43.0% | 21 | 0.1 | 1.09 | 57% | 5.5 | 0.141 | 2.885 | 14.178 | 2.77 | 4.13 | 20 | 0.9 |
| Example 21 | 2.20 | 100% | 13 | 0.05 | / | / | / | 0.180 | 2.877 | 14.171 | 2.65 | 3.70 | 13 | 1.9 |

Performance test results of the lithium-ion batteries in the examples are shown in Table 3.

**Table 3**

| Examples | Capacity loss rate after storage at 60°C for 7 days | Thickness swelling rate after storage at 60°C for 7 days | Gram capacity | High-temperature cycle capacity retention rate |
|---|---|---|---|---|
| Unit | / | / | mAh/g | / |
| Comparative Example 1 | 8.00% | 8.0% | 190 | 70.0% |
| Example 1 | 1.30% | 1.3% | 225 | 84.0% |
| Example 2 | 1.20% | 1.2% | 226 | 85.0% |
| Example 3 | 1.20% | 1.2% | 220 | 85.6% |
| Example 4 | 1.10% | 1.1% | 219 | 89.0% |
| Example 5 | 1.00% | 1.0% | 219 | 88.0% |
| Example 6 | 0.90% | 0.9% | 220 | 89.7% |
| Example 7 | 0.90% | 0.88% | 219 | 89.5% |
| Example 8 | 0.90% | 0.9% | 218 | 89.3% |
| Example 9 | 0.89% | 0.8% | 219 | 90.1% |
| Example 10 | 0.87% | 0.8% | 218 | 90.3% |
| Example 11 | 0.83% | 0.8% | 218 | 90.4% |
| Example 12 | 0.83% | 0.7% | 218 | 90.8% |
| Example 13 | 0.80% | 0.7% | 217 | 91.0% |
| Example 14 | 0.78% | 0.7% | 215 | 92.0% |
| Example 15 | 0.80% | 0.6% | 219 | 92.1% |
| Example 16 | 0.78% | 0.70% | 218 | 92.5% |
| Example 17 | 0.76% | 0.78% | 217 | 91.0% |
| Example 18 | 0.65% | 0.50% | 216 | 92.0% |
| Example 19 | 0.50% | 0.45% | 215 | 90.5% |

(continued)

| Examples | Capacity loss rate after storage at 60°C for 7 days | Thickness swelling rate after storage at 60°C for 7 days | Gram capacity | High-temperature cycle capacity retention rate |
|---|---|---|---|---|
| Unit | / | / | mAh/g | / |
| Example 20 | 0.45% | 0.40% | 210 | 95.0% |
| Example 21 | 3.2% | 5% | 211 | 81.0% |

It can be learned from the results of Comparative Example 1 and Examples 1 to 21 in Tables 1 to 3 that when the positive electrode active material includes the first monocrystalline particle having the length-diameter ratio Li greater than or equal to 2 and less than or equal to 5, overall performance of the lithium-ion battery, especially the cycling performance and storage performance at high voltage and high temperature, is improved. A reason is that the positive electrode material includes the first monocrystalline particle having the first length-diameter ratio $L_1$, and a high length-diameter ratio of the first monocrystalline particle is conducive to reducing active crystal planes which cause side reactions on a surface of the positive electrode material, and suppressing structural phase change and interface side reactions of the positive electrode material, which leads to the improved cycling performance and storage performance of the lithium-ion battery at high voltage and high temperature.

It can be learned from the results of Examples 1 to 3 and Examples 4 and 5 in Tables 1 to 3 that the surface of the first monocrystalline particle having the crack can improve the cycling performance and storage performance of the lithium-ion battery at high voltage and high temperature. A possible reason is that due to the high length-diameter ratio of the first monocrystalline particle, great stress and strain are generated by expansion and contraction caused by lithium intercalation and deintercalation in a length-diameter direction. Expansion and contraction of the first monocrystalline particle in the length-diameter direction can be buffered through the crack on the surface of the first monocrystalline particle, reducing the risk of breaking of the first monocrystalline particle, thereby improving the cycling performance and storage performance of the lithium-ion battery at high voltage and high temperature.

It can be learned from the results of Examples 1 to 5 and Examples 6 to 20 in Tables 1 to 3 that during preparation of positive electrode active material, doping one or more of doping elements such as element M (Sr, Y, Ti, Zr, Nb, Al, and B) and/or element R (F) can further improve the cycling performance and storage performance of the lithium-ion battery at high voltage and high temperature. A reason is that with element M and/or element R doped, element M can support the layered lithium nickel composite oxide and inhibit lattice defects and structural collapse. In addition, doping element M and/or element R can improve stability of a crystal structure of the first monocrystalline particle at the first crack and suppress phase change of the crystal structure and interface side reactions at the first crack, thereby improving the cycling performance and storage performance of the lithium-ion battery at high voltage and high temperature.

It can be learned from the results of Example 21 and Example 4 in Tables 1 to 3 that the lithium salt selected for ion exchange can control the percentage of the small particles. When $LiNO_3$ is used as the lithium salt, the small particles crystallize into large particles to form a pure large particle material. As compared with Example 21, due to the improvement of grading, the first monocrystalline particles with a high length-diameter ratio and the second monocrystalline particles with a low length-diameter ratio in Example 4 can pack well, resulting in a high compacted density. Under such high compacted density, a good conductive network can be formed, thereby increasing the gram capacity of the positive electrode material. In addition, the second monocrystalline particle with a low length-diameter ratio can reduce defects caused by great lattice stress of the first monocrystalline particle with a high length-diameter ratio after compaction, thereby improving the high-temperature cycling and storage performance of the lithium-ion battery.

Although illustrative embodiments have been demonstrated and described, persons skilled in the art should understand that the foregoing embodiments should not be construed as any limitation on this application, and that some embodiments may be changed, replaced, and modified without departing from the spirit, principle, and scope of this application.

## Claims

1.    A positive electrode material, wherein the positive electrode material comprises first monocrystalline particles, and the first monocrystalline particle has a first length-diameter ratio $L_1$, wherein Li satisfies $2 \leq Li \leq 5$.

2.    The positive electrode material according to claim 1, wherein the positive electrode material satisfies at least one of the following conditions:

(1) a surface of the first monocrystalline particle has a first crack; or
(2) an average particle size $D_1$ of the first monocrystalline particle is 10 $\mu$m to 25 $\mu$m.

3. The positive electrode material according to claim 2, wherein the positive electrode material satisfies at least one of the following conditions:

(1) a wall surface of the first crack comprises at least one of element P, element F, or element N; or
(2) a width h of the first crack is less than or equal to 0.1 $\mu$m.

4. The positive electrode material according to claim 1, wherein the first monocrystalline particle comprises a first lithium nickel composite oxide, and the first lithium nickel composite oxide comprises element Ni, element Na, optionally element Co, optionally element Mn, optionally element M, and optionally element R, wherein element M comprises at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and element R comprises at least one of P, F, or N; and the positive electrode material satisfies at least one of the following conditions:

(1) based on a total molar mass of element Ni, element Co, element Mn, and element M in the first lithium nickel composite oxide, a molar percentage of element Na in the first lithium nickel composite oxide is 1% to 10%;
(2) based on the total molar mass of element Ni, element Co, element Mn, and element M in the first lithium nickel composite oxide, a molar percentage of element M in the first lithium nickel composite oxide is 0.1% to 20%;
(3) based on the total molar mass of element Ni, element Co, element Mn, and element M in the first lithium nickel composite oxide, a molar percentage of element R in the first lithium nickel composite oxide is 1% to 10%;
(4) based on the total molar mass of element Ni, element Co, element Mn, and element M in the first lithium nickel composite oxide, a molar percentage of element Ni in the first lithium nickel composite oxide is greater than or equal to 50%; or
(5) the first lithium nickel composite oxide comprises $Li_{x1}Na_{w1}Ni_{y1}Co_{z1}Mn_{k1}M_{q1}O_{2\pm a}R_a$, wherein $0.2 \leq x1 \leq 1.2$, $0.5 \leq y1 \leq 1$, $0 \leq z1 \leq 0.5$, $0 \leq k1 \leq 0.5$, $0 < q1 \leq 0.2$, $0.01 \leq w1 \leq 0.1$, and $0 \leq a \leq 0.1$.

5. The positive electrode material according to claim 1, wherein the positive electrode material further comprises second monocrystalline particles, and the second monocrystalline particle has a second length-diameter ratio $L_2$, wherein $L_2$ satisfies $1 \leq L_2 < 2$; and
a quantity of the first monocrystalline particles is Ni, and a quantity of the second monocrystalline particles is $N_2$, wherein $N_1/(N_1 + N_2)$ ranges from 20% to 50%, and $N_2/(N_1 + N_2)$ ranges from 50% to 80%.

6. The positive electrode material according to claim 5, wherein the second monocrystalline particle comprises a second lithium nickel composite oxide, and the second lithium nickel composite oxide comprises element Ni, element Na, optionally element Co, optionally element Mn, optionally element M', and optionally element R', wherein element M' comprises at least one of B, Mg, Al, Si, S, Ti, Cr, Fe, Cu, Zn, Ga, Y, Zr, Mo, Ag, W, In, Sn, Pb, Sb, V, Nb, La, Ge, Sr, Ca, Ba, Ta, Hf, or Ce, and element R' comprises at least one of P, F, or N; and the positive electrode material satisfies at least one of the following conditions:

(1) based on a total molar mass of element Ni, element Co, element Mn, and element M' in the second lithium nickel composite oxide, a molar percentage of element Na in the second lithium nickel composite oxide is 1% to 10%;
(2) based on the total molar mass of element Ni, element Co, element Mn, and element M' in the second lithium nickel composite oxide, a molar percentage of element M' in the second lithium nickel composite oxide is 0.1% to 20%;
(3) based on the total molar mass of element Ni, element Co, element Mn, and element M' in the second lithium nickel composite oxide, a molar percentage of element R' in the second lithium nickel composite oxide is 1% to 10%;
(4) based on the total molar mass of element Ni, element Co, element Mn, and element M' in the second lithium nickel composite oxide, a molar percentage of element Ni in the second lithium nickel composite oxide is greater than or equal to 50%; or
(5) the second lithium nickel composite oxide comprises $Li_{x2}Na_{w2}Ni_{y2}Co_{z2}Mn_{k2}M'_{q2}O_{2\pm b}R'_b$, wherein $0.2 \leq x2 \leq 1.2$, $0.5 \leq y2 \leq 1$, $0 \leq z2 \leq 0.5$, $0 \leq k2 \leq 0.5$, $0 \leq q2 \leq 0.2$, $0.01 \leq w2 \leq 0.1$, and $0 \leq b \leq 0.1$.

**7.** The positive electrode material according to claim 5, wherein the positive electrode material satisfies at least one of the following conditions:

(1) an average particle size $D_2$ of the second monocrystalline particle is 2 $\mu$m to 8 $\mu$m;
(2) 9 $\mu$m $\leq$ $D_V$50 $\leq$ 20 $\mu$m, wherein $D_V$50 is a particle size of the positive electrode material at 50% in the cumulative volume distribution; or
(3) ($D_V$90 - $D_V$10)/$D_V$50 $\leq$ 2, wherein $D_V$90 is a particle size of the positive electrode material at 90% in the cumulative volume distribution, $D_V$10 is a particle size of the positive electrode material at 10% in the cumulative volume distribution, and $D_V$50 is a particle size of the positive electrode material at 50% in the cumulative volume distribution.

**8.** The positive electrode material according to claim 1, wherein the positive electrode material satisfies at least one of the following conditions:

(1) a full width at half maximum FWHM(003) of a peak (003) within a range of 18° to 19.2° in an XRD diffraction pattern of the positive electrode material satisfies 0.14° $\leq$ FWHM(003) $\leq$ 0.2°;
(2) a lattice parameter a of the positive electrode material satisfies 2.87Å $\leq$ a $\leq$ 2.90Å, and a lattice parameter c of the positive electrode material satisfies 14.17Å $\leq$ c $\leq$ 14.21Å; or
(3) the positive electrode material comprises a Li layer and an O layer, and an interlayer spacing between the Li layer and the O layer ranges from 2.65Å to 2.77Å.

**9.** An electrochemical apparatus, comprising the positive electrode material according to any one of claims 1 to 8.

**10.** An electronic device, comprising the electrochemical apparatus according to claim 9.

EP 4 394 939 A1

FIG. 1

FIG. 2

FIG. 3

FIG. 4

FIG. 5

FIG. 6

FIG. 7

## INTERNATIONAL SEARCH REPORT

| International application No. |
|---|
| **PCT/CN2022/112965** |

**A. CLASSIFICATION OF SUBJECT MATTER**

H01M 4/485(2010.01)i; H01M 4/505(2010.01)i; H01M 4/525(2010.01)i

According to International Patent Classification (IPC) or to both national classification and IPC

**B. FIELDS SEARCHED**

Minimum documentation searched (classification system followed by classification symbols)

H01M

Documentation searched other than minimum documentation to the extent that such documents are included in the fields searched

Electronic data base consulted during the international search (name of data base and, where practicable, search terms used)

CNPAT, WPI, EPODOC, CNKI: 正极材料, 阴极, 单晶, 晶, 裂纹, 裂缝, 长径比, 长宽比, 纵横比, positive, cathode, material, particle, crystal, crack, length, diameter, width, ratio

**C. DOCUMENTS CONSIDERED TO BE RELEVANT**

| Category* | Citation of document, with indication, where appropriate, of the relevant passages | Relevant to claim No. |
|---|---|---|
| X | CN 114665085 A (BEIJING EASPRING MATERIAL TECHNOLOGY CO., LTD.) 24 June 2022 (2022-06-24) description, paragraphs [0002] and [0027]-[0181], and claims 1-11 | 1, 9-10 |
| Y | CN 114665085 A (BEIJING EASPRING MATERIAL TECHNOLOGY CO., LTD.) 24 June 2022 (2022-06-24) description, paragraphs [0002] and [0027]-[0181], and claims 1-11 | 2-8 |
| Y | CN 112670492 A (NINGDE AMPEREX TECHNOLOGY LTD.) 16 April 2021 (2021-04-16) description, paragraphs [0006]-[0098], and claims 1-10 | 2-8 |
| A | CN 114481322 A (HUNAN CHANGYUAN LICO NEW ENERGY CO., LTD. et al.) 13 May 2022 (2022-05-13) entire document | 1-10 |
| A | CN 114703544 A (BEIJING EASPRING MATERIAL TECHNOLOGY CO., LTD.) 05 July 2022 (2022-07-05) entire document | 1-10 |
| A | KR 20190032119 A (LG CHEMICAL LTD.) 27 March 2019 (2019-03-27) entire document | 1-10 |

☑ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **01 December 2022** | **21 December 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

Form PCT/ISA/210 (second sheet) (January 2015)

**INTERNATIONAL SEARCH REPORT**

International application No.

**PCT/CN2022/112965**

**C.    DOCUMENTS CONSIDERED TO BE RELEVANT**

| Category* | Citation of document, with indication, where appropriate, of the relevant passages | Relevant to claim No. |
|---|---|---|
| A | US 2018316005 A1 (SAMSUNG ELECTRONICS CO., LTD. et al.) 01 November 2018 (2018-11-01) <br> entire document | 1-10 |
| A | CN 113363497 A (HUIZHOU EVE ENERGY CO., LTD.) 07 September 2021 (2021-09-07) <br> entire document | 1-10 |

<div style="text-align:center">

**INTERNATIONAL SEARCH REPORT**
Information on patent family members

</div>

International application No.

**PCT/CN2022/112965**

| Patent document cited in search report | | | Publication date (day/month/year) | Patent family member(s) | | | Publication date (day/month/year) |
|---|---|---|---|---|---|---|---|
| CN | 114665085 | A | 24 June 2022 | WO | 2022134617 | A1 | 30 June 2022 |
| CN | 112670492 | A | 16 April 2021 | WO | 2022134541 | A1 | 30 June 2022 |
| CN | 114481322 | A | 13 May 2022 | | None | | |
| CN | 114703544 | A | 05 July 2022 | | None | | |
| KR | 20190032119 | A | 27 March 2019 | KR | 102332342 | B1 | 30 November 2021 |
| US | 2018316005 | A1 | 01 November 2018 | KR | 20180121267 | A | 07 November 2018 |
| | | | | KR | 102402388 | B1 | 26 May 2022 |
| | | | | US | 10938030 | B2 | 02 March 2021 |
| CN | 113363497 | A | 07 September 2021 | | None | | |

Form PCT/ISA/210 (patent family annex) (January 2015)